# EUROPEAN PATENT SPECIFICATION

(11) **EP 2 416 351 B1**
(45) Date of publication and mention of the grant of the patent: **07.08.2019**
(21) Application number: 09842709.9
(22) Date of filing: 10.12.2009
(51) Int. Cl.: H01L 21/3065, H05H 1/46, H01J 37/32

(54) **PLASMA ETCHING APPARATUS**
PLASMAÄTZVORRICHTUNG
APPAREIL DE GRAVURE AU PLASMA

(30) Priority: 31.03.2009 JP 2009084137
(43) Date of publication of application: 08.02.2012
(73) Proprietor: SPP Technologies Co., Ltd., Chiyoda-ku, Tokyo 1000-0004 (JP)
(72) Inventor: YAMAMOTO, Takashi, Amagasaki-shi Hyogo 660-0891 (JP); NOZAWA, Yoshiyuki, Amagasaki-shi Hyogo 660-0891 (JP)
(74) Representative: Isarpatent
(86) International application number: PCT/JP2009/070643
(87) International publication number: WO 2010/113358

(56) References cited:
- WO-A2-2005/034163
- JP-A- 2001 007 083
- JP-A- 2004 079 465
- JP-A- 2004 241 437
- US-A1- 2003 092 278

## Description

### Technical Field

0001 The present invention relates to a plasma etching apparatus for etching the surface of a substrate, such as a silicon substrate, a glass substrate and the like, with a plasma generated from an etching gas.

### Background Art

0002 As an apparatus for plasma etching a silicon substrate, conventionally, the apparatuses disclosed in the Japanese Unexamined Patent Application Publication Nos. 2006-80504 (prior-art example 1) and 2006-60089 (prior-art example 2) are known.

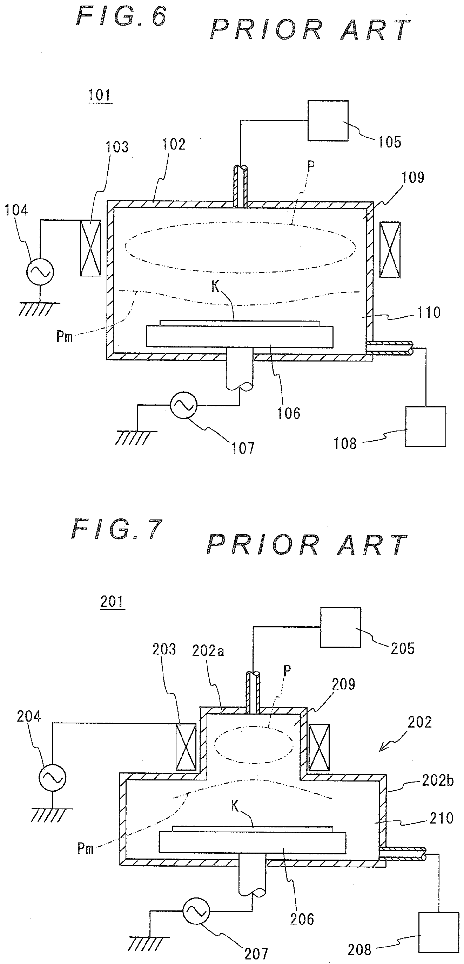

0003 As shown in Fig. 6, a plasma etching apparatus 101 of the prior-art example 1 has a cylindrical chamber 102 having a plasma generating space 109 defined at the upper side and a processing space 110 defined at the lower side, a coil 103 disposed on the outside of the chamber 102 corresponding to the plasma generating space 109 in such a manner that it winds around the chamber 102, RF power supply means 104 for supplying RF power to the coil 103, etching gas supply means 105 for supplying an etching gas into the plasma generating space 109, a platen 106 which is disposed in the processing space 110 and on which a substrate is to be placed, RF power supply means 107 for supplying RF power to the platen 106, and exhaust means 108 for exhausting the gas within the chamber 102.

0004 In this plasma etching apparatus 101, an inductive electric field is generated in the plasma generating space 109 by applying RF power to the coli 103, plasma is generated from an etching gas supplied into the plasma generating space 109 due to this inductive electric field, and a substrate K on the platen 106 is etched by the generated plasma.

0005 On the other hand, as shown in Fig. 7, a plasma etching apparatus 201 of the prior-art example 2 has a chamber 202, which is similarly formed in a cylindrical shape, comprising a small-diameter portion 202a at the upper side and a large-diameter portion 202b at the lower side. A coil 203 is disposed on the outside of the small-diameter portion 202a in such a manner that it winds around the small-diameter portion 202a, and the inside of the small-diameter portion 202a is defined as a plasma generating space 209. The inside of the large-diameter portion 202b is defined as a processing space 210, and a platen 206 on which a substrate is to be placed is disposed in the processing space 210.

0006 RF power supply means 204 supplies RF power to the coil 203, and on the other hand, RF power supply means 207 supplies RF power to the platen 206. Further, etching gas supply means 205 supplies an etching gas into the plasma generating space 209, and exhaust means 208 exhausts the gas within the chamber 202.

0007 According to this plasma etching apparatus 201, similarly to the plasma etching apparatus 101 of the prior-art example 1, an inductive electric field is generated in the plasma generating space 209 by applying RF power to the coil 203, plasma is generated from an etching gas supplied into the plasma generating space 209 due to this inductive electric field, and a substrate K on the platen 206 is etched by the generated plasma.

### Citation List

### Patent Literature

0008
*Patent document 1:* Japanese Unexamined Patent Application Publication No. 2006-80504
*Patent document 2:* Japanese Unexamined Patent Application Publication No. 2006-60089

### Summary of Invention

### Technical Problem

0009 By the way, in recent years, a substrate to be processed has increased in size and therefore there has been a demand for a plasma etching apparatus capable of etching the entire surface of such a large-sized substrate uniformly.

0010 However, when such a large-sized substrate is processed by the above conventional plasma etching apparatus 101 or 201, there are problems as described below.

0011 That is, with respect to the plasma etching apparatus 101, since the plasma generating space 109 is large, the plasma etching apparatus 101 can be structurally easily adapted to a relatively large substrate. However, if the chamber 102 is made larger and the plasma generating space 109 is made larger corresponding to the increase of the size of the substrate K, the in-plane density Pm of the plasma generated in the plasma generating space 109 has a concave density distribution in which the density is high at the portion close to the coil 103 and is low at the central portion, and this density distribution acts on the substrate K as it is. Therefore, the surface of the substrate K is not etched uniformly.

0012 Particularly, at the periphery portion of the substrate K, the etching rate is higher than that at the central portion thereof even if the in-plane density Pm of the plasma is uniform, and therefore the etching is apt to proceed fast. Therefore, in a case where the in-plane density Pm of the plasma has a concave density distribution as described above, the etching at the periphery portion of the substrate K proceeds faster and it is not possible to etch the entire surface of the substrate K uniformly.

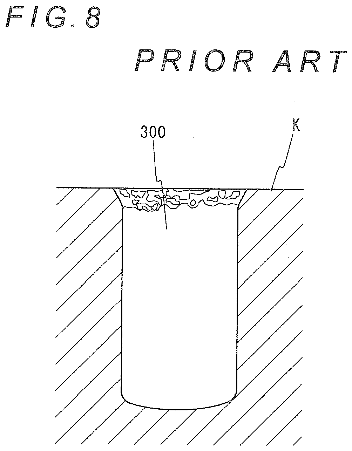

0013 Further, the high plasma density at the periphery portion of the substrate K causes a problem that when a deep hole, for example, is formed in the substrate K, as shown in Fig. 8, the periphery of the entrance of a hole 300 is etched by a high density of ions and thereby the entrance is formed into a tapered shape and the surface thereof becomes rough because of sputtering, which results in deterioration of etching shape.

0014 On the other hand, with respect to the plasma etching apparatus 201, the volume of the plasma generating space 209 is small and therefore it is possible to generate high-density plasma even if the RF power applied to the coil 203 is low, and the in-plane density Pm of the plasma has a convex density distribution. Therefore, although it is possible to etch the entire surface of the substrate K uniformly when the substrate K is a relatively small, if only the processing space 210 is made larger corresponding to the increase of the size of the substrate K without changing the plasma generating space 209, it is difficult to cause the plasma generated in the plasma generating space 209 to act on the periphery portion of the substrate K, and therefore, also in this case, it is not possible to etch the entire surface of the substrate K uniformly.

0015 Alternatively, if the plasma generating space 209 is also made larger corresponding to the increase of the size of the substrate K, a problem similar to that in the case of the plasma etching apparatus 101 described above is caused.

WO 2005/034163 A2 describes an apparatus and a method for plasma treating a substrate. The apparatus has a chamber and a plasma generator which forms a plasma from one or more gases flowing within the chamber so as to produce one or more species for interacting with the substrate placed within the chamber. A guide is provided for directing the gas flow containing the species towards the substrate. When in use, the width of the plasma is greater than that of the substrate by an amount defining an outer region of plasma. The guide is adapted to direct the species from at least substantially all of the outer region of the plasma towards the substrate.

0016 The present invention has been achieved in view of the above-described circumstances, and an object thereof is to provide a substrate processing apparatus capable of etching the entire surface of a substrate uniformly even if the substrate is large-sized and capable of preventing a deterioration of shape caused by ions.

### Solution to Problem

0017 The present invention, for solving the above-described problem, provides a plasma etching apparatus with the features of claim 1.

0018 According to this plasma etching apparatus, first of all, RF power is applied to the coil by the power supply means for coil. Thereby, an inductive electric field is generated in the plasma generating space in the chamber. Under this condition, when a processing gas is supplied into the plasma generating space by the processing gas supply means, plasma is generated form the supplied processing gas due to the inductive electric field.

0019 The in-plane density of the plasma thus generated has a concave density distribution in which the density is high at the periphery portion which is close to the coil and the density is low at the central portion.

0020 The plasma having such a concave density distribution flows downward and flows through the cylindrical plasma density adjusting member having an opening at the top and an opening at the bottom, reaches a substrate placed on the platen which is positioned below the plasma density adjusting member, and etches the surface of the substrate.

0021 Since the plasma density adjusting member is formed in a funnel shape the lower end portion of which has an inner diameter smaller than the inner diameter of the upper end portion thereof and than the inner diameter of the body portion forming the plasma generating space, the in-plane density of the plasma which has an extremely concave density distribution is equalized or is adjusted to have a somewhat convex density distribution in reverse by flowing the plasma through the plasma density adjusting member, after which the plasma reaches the substrate.

0022 Further, although, as described above, the density of the plasma generated in the plasma generating space is high at the periphery portion thereof, that is, the ion density is also high there, since the plasma density adjusting member of the present invention is made of a conductive material grounded, a high density of ions existing at the periphery portion of the plasma is neutralized by contacting with the plasma density adjusting member while the plasma passes through the plasma density adjusting member, and thereby the ion density at the periphery portion is reduced.

0023 Therefore, it is possible to improve the above-described problem that a high density of ions causes deterioration of etching shape.

0024 It is noted that an object of the present invention is to etch the entire surface of a substrate uniformly even if the substrate is large-sized, that is, to equalize the etching rate throughout the entire surface of a substrate. According to the knowledge of the inventors of the invention, it is necessary, for achieving the above object, that the in-plane density of the plasma has a gradual concave density distribution or a gradual convex density distribution depending on various conditions such as mask opening ratio of substrate, substrate size etc. By using the above plasma density adjusting member and appropriately setting the length thereof and the inner diameter of the lower end portion thereof, the in-plane density of the plasma can be adjusted to have such a density distribution. As a result thereof, it is possible to etch the entire surface of the substrate uniformly.

0025 It is noted that it is preferable to provide, in the plasma etching apparatus, a cylindrical core member at the central portion of the top plate, which core member hangs downward from the top plate to form the plasma generating space in a doughnut shape.

0026 When thus configured, it is possible to reduce the volume of the plasma generating space and thereby to generate high-density plasma by supplying a relatively low RF power to the coil. Therefore, it is possible to enhance energy efficiency.

0027 Furthermore, it is preferable that the core member is made of a non-conductive material. When the core member is made of a conductive material and is provided, ions in the plasma generated in the plasma generating space disappear, and, as a result thereof, the plasma density is reduced. When the core member is made of a non-conductive material, it is possible to prevent the reduction of the plasma density.

### Advantageous Effects of Invention

0028 According to the plasma etching apparatus of the invention, the in-plane density of plasma can be adjusted to become in a most suitable state by flowing the plasma through said plasma density adjusting member, and, as a result thereof, it is possible to etch the entire surface of a substrate uniformly.

### Brief Description of Drawings

0029
Fig. 1 is a front sectional view of a plasma etching apparatus according to one embodiment of the present invention;
Fig. 2 is an illustration for explaining an etching shape obtained when trench etching is performed by the plasma etching apparatus according to the embodiment;
Fig. 3 is a sectional view of a plasma density adjusting member according to the embodiment;
Fig. 4 is a graph relating to an etching rate when etching is performed after adjusting the plasma density using the plasma density adjusting member according to the embodiment;
Fig. 5 is a graph relating to etching rates when etching is performed after adjusting the plasma density using the plasma density adjusting member according to the embodiment;
Fig. 6 is a front sectional view of a plasma etching apparatus according to a prior-art example;
Fig. 7 is a front sectional view of a plasma etching apparatus according to a prior-art example; and
Fig. 8 is an illustration for explaining an etching shape obtained when trench etching is performed by the plasma etching apparatus according to one of the prior-art examples.

### Description of Embodiments

0030 Hereinafter, a preferable embodiment of the present invention will be described on the basis of the drawings.

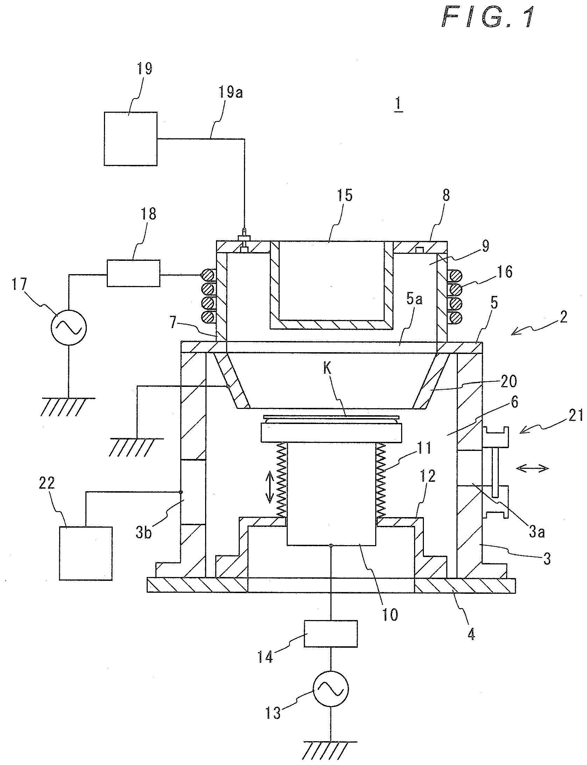

0031 As shown in Fig. 1, a plasma etching apparatus 1 of the embodiment has a chamber 2 comprising a lower body portion 3, an upper body portion 7, a bottom plate 4, an intermediate plate 5, and a top plate 8. The lower body portion 3, the upper body portion 7, the bottom plate 4, the intermediate plate 5 and the top plate 8 are each made of a non-conductive material (for example, ceramics), and the upper body portion 7 and the lower body portion 3 are formed in a cylindrical shape.

0032 The bottom plate 4 is fixed on the lower end portion of the lower body portion 3 and the intermediate plate 5 is fixed on the upper end portion of the lower body portion 3, and the lower body portion 3, the bottom plate 4 and the intermediate plate 5 form a processing space 6.

0033 In the processing space 6, a platen 10 is disposed on which a substrate K is to be placed and the platen 10 is lifted up and down by an appropriate lifting mechanism. An RF power supply unit 13 is connected to the platen 10 via a matching unit 14, and RF power is supplied to the platen 10 by the RF power supply unit 13. It is noted that the reference numeral 11 indicates a cover covering the outer peripheral portion of the platen 10 and the reference numeral 12 indicates a support for supporting the lifting of the platen 10.

0034 The lower body portion 3 has an opening 3a for loading and unloading the substrate K and an exhaust port 3b for exhausting the gas within the processing space 6 formed therein. The opening 3a is opened and closed by a shutter mechanism 21, and the exhaust port 3b is connected to an exhaust device 22 and the gas within the processing space 6 is exhausted by the exhaust device 22.

0035 The upper body portion 7 is fixed on the intermediate plate 5 and the top plate 8 is fixed on the upper end portion of the upper body portion 7. On the central portion of the top plate 8, a cup-shaped core member 15 is fixed in such a manner that it hangs downward from the top plate 8. Thus, a doughnut-shaped plasma generating space 9 is formed by the upper body portion 7, the top plate 8 and the core member 15. It is noted that the inner diameter of the upper body portion 7 is larger than the outer diameter of the substrate K.

0036 The intermediate plate 5 has an opening 5a formed therein and a plasma density adjusting member 20 which is formed in a funnel shape having an opening at the top and an opening at the bottom is fixedly provided on the lower surface of the intermediate plate 5. The plasma generating space 9 and the processing space 6 communicate with each other via the opening 5a and the plasma density adjusting member 20. The plasma density adjusting member 20 is positioned between the plasma generating space 9 and the substrate K, and is made of a conductive material (for example, aluminum) and is appropriately grounded. Further, the inner diameter of the lower end portion of the plasma density adjusting member is smaller than the inner diameter of the upper body portion 7.

0037 A coil 16 is disposed on the outside of the upper body portion 7 in such a manner that it winds around the upper body portion 7, and is connected to an RF power supply unit 17 via a matching unit 18. The RF power supply unit 17 supplies RF power to the coil 16.

0038 Further, a supply pipe 19a connecting to an etching gas supply source 19 is connected to the top plate 5, and an etching gas is supplied into the plasma generating space 9 from the etching gas supply source 19.

0039 According to the plasma etching apparatus 1 of the embodiment having the above-described configuration, initially, a substrate K (for example, a silicon substrate) is placed, through the opening 3a, on the platen 10 which is at a lowered position. Subsequently, the platen 10 is lifted up to a processing position and the processing space 6 and the plasma processing space 9 are brought to a negative pressure by the exhaust device 22, and RF power is supplied to the platen 10 from the RF power supply unit 13.

0040 Further, RF power is supplied to the coil 16 from the RF power supply unit 17, and thereby an inductive electric field is generated in the plasma generating space 9. Under this state, an etching gas (for example, SF₆ gas) is supplied into the plasma generating space 9 from the etching gas supply source 19 and plasma is generated from the etching gas due to the inductive electric field.

0041 Since the plasma generating space 9 is, as described above, formed in a doughnut shape by the cylindrical core member 15, the volume thereof is small. Further, since only the region close to the coil 16 is defined as the plasma generating space 9, high-density plasma can be generated even when the power applied to the coil 16 is relatively low.

0042 The high-density plasma thus generated flows downward and flows through the plasma density adjusting member 20, and reaches the substrate K positioned below the plasma density adjusting member 20 and etches the surface of the substrate K. It is noted that the in-plane density of the plasma flowing downward from the plasma generating space 9 has a concave density distribution in which the density is extremely high at the periphery portion and is low at the central portion.

0043 While the plasma having such a density distribution passes through the plasma density adjusting member 20, since the plasma density adjusting member 20 is formed in a funnel shape the lower opening of which has an inner diameter smaller than the inner diameter of the upper body portion 7, the plasma is gradually concentrated and the in-plane density thereof is gradually equalized, and thereby the in-plane density of the plasma is adjusted to have a gradual concave density distribution or to have a flat uniform density distribution or to have a gradual convex density distribution, after which the plasma reaches the substrate.

0044 Thus, the high-density plasma adjusted as described above acts on the surface of the substrate, and thereby the entire surface of the substrate is etched uniformly.

0045 Further, in the embodiment, a bias potential is applied to the substrate K by applying RF power to the platen 10. Therefore, ions in the plasma are irradiated toward the substrate K, and thereby so-called ion assisted etching is performed.

0046 Since the plasma density adjusting member 20 is made of a conductive material grounded, while the plasma passes through the plasma density adjusting member 20, a high density of ions existing at the periphery portion of the plasma is neutralized by contacting with the plasma density adjusting member 20, and thereby disappears. Therefore, the problem that deterioration of etching shape is resulted from a high density of ions acting on the substrate is solved.

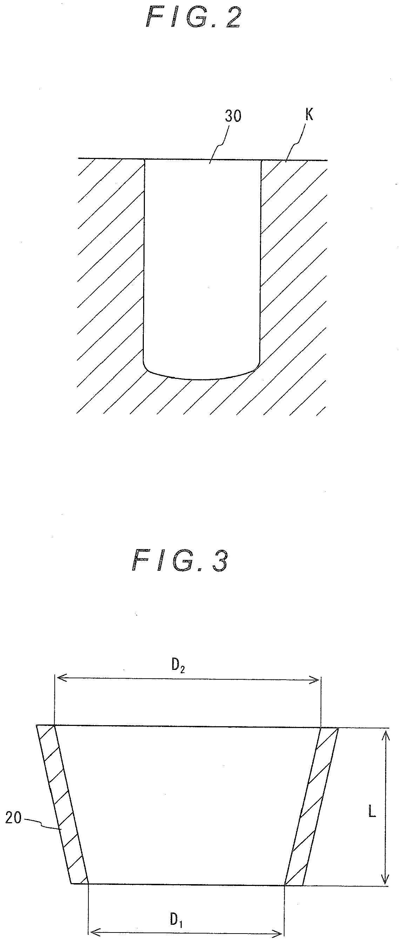

0047 In this connection, Fig. 2 shows the result of the formation of a deep hole in the substrate K using the plasma etching apparatus 1 of the embodiment. As shown in Fig. 2, the entrance of a hole 30 is not formed into a tapered shape and further the surface thereof is not rough.

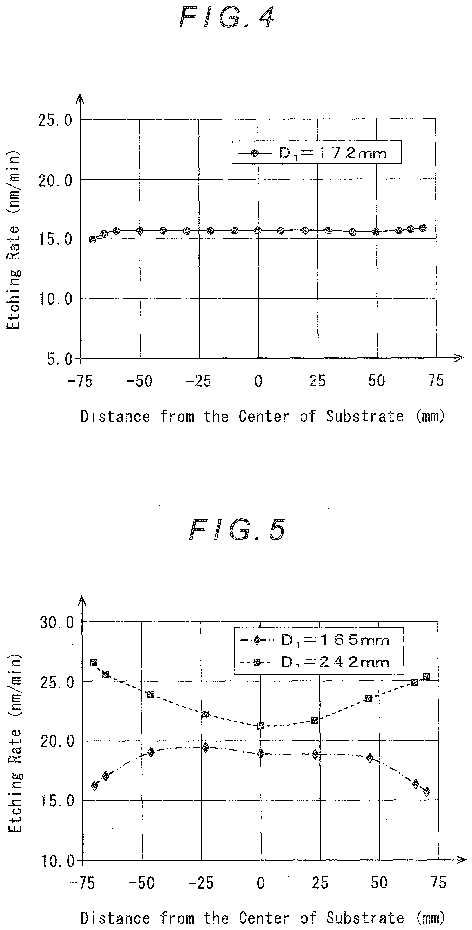

0048 Further, Fig. 4 shows the result of the etching of a SiO₂ film on a silicon substrate of 6 inches, wherein the plasma etching apparatus 1 of the embodiment as shown in Fig. 1 was used, SF₆ gas was used as etching gas, the flow rate of the SF₆ gas supplied into the plasma generating space 9 was 500 ml/min, the RF power applied to the coil 16 was 2000 W, the RF power applied to the platen 10 was 70 W, and the dimensions of the plasma density adjusting member 20 as shown in Fig. 3, that is, the lower-end inner diameter D₁, upper-end inner diameter D₂ and length L thereof were 172 mm, 270 mm and 106 mm, respectively.

0049 As shown in Fig. 4, in the exampled etching, the entire surface of the substrate K could be etched with an extremely high etching-rate uniformity of 15.5 nm/min ± 3.1 %.

0050 Further, Fig. 5 shows the result of the etching when the D₁ and the length L of the plasma density adjusting member 20 were set to 165 mm and 86 mm, respectively and the result of the etching when the D₁ and the length L of the plasma density adjusting member 20 were set to 242 mm and 86 mm, respectively. As shown in Fig. 5, the etching rate throughout the entire surface of the substrate K was 17.8 nm/min ± 10.1 % when the D₁ was 165 mm, and the etching rate throughout the entire surface of the substrate K was 23.9 nm/min ± 11.1 % when the D₁ was 242 mm.

0051 As seen form there examples, adjusting the dimensions of the plasma density adjusting member 20 appropriately enables the entire surface of the substrate K to be processed uniformly. Further, as seen from Fig. 4, setting the dimensions of the plasma density adjusting member 20 to the optimum conditions enables the entire surface of the substrate K to be etched with an extremely high uniformity.

0052 It is noted that the core member 15 is preferably made of a non-conductive material. When the core member 15 is made of a conductive material and is provided, ions in the plasma generated in the plasma generating space 9 disappear, and, as a result thereof, the density of the plasma is reduced. When the core member 15 is made of a non-conductive material, it is possible to prevent the reduction of the density of the plasma.

0053 Thus, one embodiment of the present invention has been described. However, a specific embodiment in which the present invention can be implemented is not limited thereto. For example, although the core member 15 is provided in the above embodiment, it is not necessarily provided.

### Industrial Applicability

0054 As described above, the plasma etching apparatus of the present invention can be suitably used as a plasma etching apparatus capable of etching the entire surface of a substrate with an extremely high uniformity.

### Reference Signs List

0055
- 1: Plasma etching apparatus
- 2: Chamber
- 3: Lower body portion
- 4: Bottom plate
- 5: Intermediate plate
- 6: Processing space
- 7: Upper body portion
- 8: Top plate
- 9: Plasma generating space
- 10: Platen
- 13: RF power supply unit
- 15: Core member
- 16: Coil
- 17: RF power supply unit
- 19: Etching gas supply source
- 20: Plasma density adjusting member

## Claims

1. A plasma etching apparatus (1) comprising:
a chamber (2) which comprises a cylindrical body portion, a top plate (8) for closing the top of the body portion, and a bottom plate (4) for closing the bottom of the body portion, and which has a plasma generating space (9) defined in an upper region in the body portion and a processing space (6) defined below the plasma generating space (9);
a coil (16) disposed on the outside of a portion of the chamber (2) corresponding to the plasma generating space (9) in such a manner that it winds around the chamber (2);
a platen (10) which is disposed in the processing space (6) in the chamber (2) and on which a substrate (K) to be processed is to be placed;
processing gas supply means (19) for supplying a processing gas into the plasma generating space (9) in the chamber (2);
power supply means (17) for the coil (16) configured to supply RF power to the coil (16);
power supply means (13) for the platen (10) configured to supply RF power to the platen (10); and
a plasma density adjusting member (20) which comprises a cylindrical member having an opening at the top and an opening at the bottom, and the upper end portion of which is fixed on an inner wall of the chamber (2) between the plasma generating space (9) and the platen (10), and which adjusts the in-plane density of a plasma generated in the plasma generating space (9) and guides the plasma to a substrate on the platen (10),
the body portion forming the plasma generating space (9) is formed to have an inner diameter larger than the outer dimension of the substrate (K), and
the plasma density adjusting member (20) is made of a conductive material and is formed in a funnel shape the lower end portion of which has an inner diameter smaller than the inner diameter of the upper end portion thereof and than the inner diameter of the body portion forming the plasma generating space (9),
**characterized in that**
the plasma density adjusting member (20) is made of a conductive material grounded; and
a plane defined by the upper end portion and a plane defined by the lower end portion of the plasma density adjusting member (20) are substantially parallel with each other and an angle formed by the planes and a funnel-shaped surface of the plasma density adjusting member (20) is within a range of 59 to 81 degrees.

2. The plasma etching apparatus (1) according to claim 1, **characterized in that** the plasma generating space (9) is formed in a doughnut shape by providing at the central portion of the top plate (8) a cylindrical core member (15) which hangs downward from the top plate (8).

3. The plasma etching apparatus (1) according to claim 2, **characterized in that** the core member (15) is made of a non-conductive material.

4. The plasma etching apparatus (1) according to claim 1, **characterized in that**
the body portion comprises an upper body portion (7) and a lower body portion (3) having an inner diameter larger than that of the upper body portion (7);
the chamber (2) further comprises an intermediate plate (5) provided at an upper portion of the lower body portion (3);
the plasma generating space (9) is formed by the top plate (8) and the upper body portion (7); and
the processing space (6) is formed by the lower body portion (3), the intermediate plate (5) and the bottom plate (4).

5. The plasma etching apparatus (1) according to claim 1, **characterized in that** the plasma density adjusting member (20) is made of aluminum.

## Patentansprüche

1. Plasmaätzvorrichtung (1), umfassend:
eine Kammer (2), die einen zylindrischen Körperabschnitt, eine Deckplatte (8) zum Schließen des Deckenteils des Körperabschnitts, und eine Bodenplatte (4) zum Schließen des Bodenteils des Körperabschnitts umfasst und die einen Plasmaerzeugungsraum (9), der in einem oberen Bereich in dem Körperabschnitt definiert ist, und einen Verarbeitungsraum (6), der unter dem Plasmaerzeugungsraum (9) definiert ist, aufweist;
eine Spule (16), die auf der Außenseite eines Abschnitts der Kammer (2), der dem Plasmaerzeugungsraum (9) entspricht, in einer derartigen Weise angeordnet ist, dass sie sich um die Kammer (2) wickelt;
eine Platte (10), die in dem Verarbeitungsraum (6) in der Kammer (2) angeordnet ist und auf der ein zu verarbeitendes Substrat (K) platziert ist;
Prozessgaszuführmittel (19) zum Zuführen eines Prozessgases in den Plasmaerzeugungsraum (9) in der Kammer (2);
Leistungsversorgungsmittel (17) für die Spule (16), die ausgestaltet sind, um der Spule (16) RF-Leistung zuzuführen;
Leistungsversorgungsmittel (13) für die Platte (10), die ausgestaltet sind, um der Platte (10) Leistung zuzuführen; und
ein Plasmadichte-Einstellelement (20), das ein zylindrisches Element mit einer Öffnung an dem Deckenteil und einer Öffnung an dem Bodenteil umfasst und dessen oberer Endabschnitt auf einer inneren Wand der Kammer (2) zwischen dem Plasmaerzeugungsraum (9) und der Platte (10) befestigt ist und das die Dichte eines Plasmas, das in dem Plasmaerzeugungsraum (9) erzeugt wird, in der Ebene einstellt und das Plasma zu einem Substrat auf der Platte (10) führt,
wobei der Körperabschnitt, der den Plasmaerzeugungsraum (9) bildet, gebildet ist, um einen inneren Durchmesser aufzuweisen, der größer ist als der äußere Durchmesser des Substrats (K), und
das Plasmadichte-Einstellelement (20) aus einem leitfähigen Material hergestellt ist und in einer Trichterform gebildet ist, dessen unterer Endabschnitt einen inneren Durchmesser aufweist, der kleiner ist als der innere Durchmesser des oberen Endabschnitts davon und als der innere Durchmesser des Körperabschnitts, der den Plasmaerzeugungsraum (9) bildet,
**dadurch gekennzeichnet ist, dass**
das Plasmadichte-Einstellelement (20) aus einem geerdeten leitfähigen Material hergestellt ist; und
eine Ebene, die durch den oberen Endabschnitt definiert ist, und eine Ebene, die durch den unteren Endabschnitt gebildet ist, des Plasmadichte-Einstellelements (20) im Wesentlichen parallel zueinander sind und ein Winkel, der durch die Ebenen und eine trichterförmige Fläche des Plasmadichte-Einstellelements (20) gebildet ist, innerhalb eines Bereichs von 59 bis 81 Grad liegt.

2. Plasmaätzvorrichtung (1) nach Anspruch 1, **dadurch gekennzeichnet, dass** der Plasmaerzeugungsraum (9) in einer Donutform gebildet ist, durch Bereitstellen an dem mittigen Abschnitt der Deckplatte (8) eines zylindrischen Kernelements (15), das von der Deckplatte (8) nach unten hängt.

3. Plasmaätzvorrichtung (1) nach Anspruch 2, **dadurch gekennzeichnet, dass** das Kernelement (15) aus einem nicht leitfähigen Material hergestellt ist.

4. Plasmaätzvorrichtung (1) nach Anspruch 1, **dadurch gekennzeichnet, dass**
der Körperabschnitt einen oberen Körperabschnitt (7) und einen unteren Körperabschnitt (3) umfasst, der einen inneren Durchmesser aufweist, der größer ist als der des oberen Körperabschnitts (7);
die Kammer (2) ferner eine Zwischenplatte (5) umfasst, die an einem oberen Abschnitt des unteren Körperabschnitts (3) bereitgestellt ist;
der Plasmaerzeugungsraum (9) durch die Deckplatte (8) und den oberen Körperabschnitt (7) gebildet ist; und
der Verarbeitungsraum (6) durch den unteren Körperabschnitt (3), die Zwischenplatte (5) und die Bodenplatte (4) gebildet ist.

5. Plasmaätzvorrichtung (1) nach Anspruch 1, **dadurch gekennzeichnet, dass** das Plasmadichte-Einstellelement (20) aus Aluminium hergestellt ist.

## Revendications

1. Appareil de gravure au plasma (1) comprenant :
une chambre (2) qui comprend une partie de corps cylindrique, une plaque supérieure (8) destinée à fermer le haut de la partie de corps, et une plaque inférieure (4) destinée à fermer le bas de la partie de corps, et qui comporte un espace de génération de plasma (9) défini dans une zone supérieure de la partie de corps et un espace de traitement (6) défini sous l'espace de génération de plasma (9) ;
une bobine (16) disposée sur l'extérieur d'une partie de la chambre (2) correspondant à l'espace de génération de plasma (9) de telle manière qu'elle s'enroule autour de la chambre (2) ;
une table (10) qui est disposée dans l'espace de traitement (6) dans la chambre (2) et sur laquelle un substrat (K) à traiter doit être placé ;
des moyens d'alimentation en gaz de traitement (19) destinés à alimenter un gaz de traitement dans l'espace de génération de plasma (9) dans la chambre (2) ;
des moyens d'alimentation (17) pour la bobine (16) conçus pour alimenter la bobine (16) en puissance radioélectrique ;
des moyens d'alimentation (13) pour la table (10) conçus pour alimenter la table (10) en puissance radioélectrique ; et
un élément de réglage de la densité du plasma (20) qui comprend un élément cylindrique doté d'une ouverture en haut et d'une ouverture en bas, et dont la partie d'extrémité supérieure est fixée sur une paroi intérieure de la chambre (2) entre l'espace de génération de plasma (9) et la table (10), et qui règle la densité dans le plan d'un plasma généré dans l'espace de génération de plasma (9) et guide le plasma jusqu'à un substrat sur la table (10),
la partie de corps formant l'espace de génération de plasma (9) étant formée de manière à présenter un diamètre intérieur supérieur à la dimension extérieure du substrat (K), et
l'élément de réglage de la densité du plasma (20) étant réalisé en un matériau conducteur et présentant une forme d'entonnoir, dont la partie d'extrémité inférieure présente un diamètre intérieur inférieur au diamètre intérieur de la partie d'extrémité supérieure de celui-ci et que le diamètre intérieur de la partie de corps formant l'espace de génération de plasma (9),
**caractérisé en ce que**
l'élément de réglage de la densité du plasma (20) est réalisé en un matériau conducteur mis à la terre ; et
un plan défini par la partie d'extrémité supérieure et un plan défini par la partie d'extrémité inférieure de l'élément de réglage de la densité du plasma (20) sont sensiblement parallèles entre eux et un angle formé par les plans et une surface en forme d'entonnoir de l'élément de réglage de la densité du plasma (20) est compris dans une plage de 59 à 81 degrés.

2. Appareil de gravure au plasma (1) selon la revendication 1, **caractérisé en ce que** l'espace de génération de plasma (9) est réalisé de forme torique en ménageant dans la partie centrale de la plaque supérieure (8) un élément de noyau cylindrique (15) qui est suspendu vers le bas depuis la plaque supérieure (8).

3. Appareil de gravure au plasma (1) selon la revendication 2, **caractérisé en ce que** l'élément de noyau (15) est réalisé en un matériau non conducteur.

4. Appareil de gravure au plasma (1) selon la revendication 1, **caractérisé en ce que**
la partie de corps comprend une partie de corps supérieure (7) et une partie de corps inférieure (3) présentant un diamètre intérieur supérieur à celui de la partie de corps supérieure (7) ;
la chambre (2) comprend en outre une plaque intermédiaire (5) prévue sur une partie supérieure de la partie de corps inférieure (3) ;
l'espace de génération de plasma (9) est formé par la plaque supérieure (8) et la partie de corps supérieure (7) ; et l'espace de traitement (6) est formé par la partie de corps inférieure (3), la plaque intermédiaire (5) et la plaque inférieure (4).

5. Appareil de gravure au plasma (1) selon la revendication 1, **caractérisé en ce que** l'élément de réglage de la densité du plasma (20) est réalisé en luminium.
